# FASCICULE DE BREVET EUROPEEN

(11) **EP 1 168 442 B1**
(45) Date de publication et mention de la délivrance du brevet: **01.04.2009**
(21) Numéro de dépôt: 01202292.7
(22) Date de dépôt: 13.06.2001
(51) Int. Cl.: H01L 23/522, H01L 23/64

(54) **Circuit intégré incluant un élément inductif de facteur de qualité élevé et présentant une grande compacité**
Integrierte Schaltung mit Induktanz von hohem Gütefaktor und grosser Kompaktheit
Integrated circuit with high-Q inductor and high compactness

(30) Priorité: 20.06.2000 FR 0007864
(43) Date de publication de la demande: 02.01.2002
(73) Titulaire: NXP B.V., 5656 AG Eindhoven (NL)
(72) Inventeur: Butaye, Benoit, Société Civile S.P.I.D., 75008 Paris (FR); Gamand, Patrice, Société Civile S.P.I.D., 75008 Paris (FR)
(74) Mandataire: Williamson, Paul Lewis

(56) Documents cités:
- EP-A- 0 855 741
- PATENT ABSTRACTS OF JAPAN vol. 1999, no. 12, 29 octobre 1999 (1999-10-29) -& JP 11 176639 A (FUJI ELECTRIC CO LTD), 2 juillet 1999 (1999-07-02)
- PATENT ABSTRACTS OF JAPAN vol. 1999, no. 03, 31 mars 1999 (1999-03-31) -& JP 10 321802 A (TOSHIBA CORP), 4 décembre 1998 (1998-12-04)
- PATENT ABSTRACTS OF JAPAN vol. 014, no. 252 (E-0934), 30 mai 1990 (1990-05-30) -& JP 02 072660 A (KAWASAKI STEEL CORP), 12 mars 1990 (1990-03-12)
- PATENT ABSTRACTS OF JAPAN vol. 1995, no. 06, 31 juillet 1995 (1995-07-31) -& JP 07 074311 A (TOSHIBA CORP), 17 mars 1995 (1995-03-17)
- PATENT ABSTRACTS OF JAPAN vol. 010, no. 302 (E-445), 15 octobre 1986 (1986-10-15) -& JP 61 115302 A (ASAHI CHEM IND CO LTD), 2 juin 1986 (1986-06-02)

## Description

L'invention concerne un circuit intégré comprenant au moins un substrat, une couche conductrice, un élément inductif superposé à la couche conductrice, constitué par une spire métallique présentant un contour extérieur et un contour intérieur délimitant entre eux une surface dite de rayonnement, et des moyens pour isoler la couche conductrice de l'élément inductif.

Un tel circuit intégré est connu du document PCT/US98/05149. L'élément inductif inclus dans ce circuit intégré possède un facteur de qualité élevé qui est obtenu grâce à la présence d'un blindage conducteur placé entre le substrat et l'élément inductif. Le blindage connu permet de réduire, d'une part, les pertes énergétiques en réduisant les courants circulant par induction dans le substrat et, d'autre part, les pertes magnétiques en limitant la distance parcourue par ces courants qui abaissent le facteur de qualité de l'élément inductif.

L'invention est liée aux considérations suivantes :

Dans l'art antérieur, le blindage est réalisé au moyen de plaques occupant toute la surface délimitée par le contour extérieur de la surface de rayonnement. Une surface, dite surface interne, délimitée par le contour intérieur de la surface de rayonnement est une surface perdue au sein même du circuit, en ce sens qu'elle ne peut être utilisée à d'autres fins que des fins de blindage.

Un but de l'invention est de permettre l'intégration d'autres éléments au sein d'un circuit conforme au paragraphe introductif, sans pour autant que l'encombrement dudit circuit ne s'en trouve augmenté et sans que le fonctionnement desdits autres éléments ne soit perturbé par l'élément inductif.

L'invention est définie par la revendication 1.

. La zone active comporte des éléments capacitifs, résistifs ou semi-conducteurs. L'invention peut donc être mise en oeuvre dans tout circuit intégré où un élément inductif coexiste avec d'autres éléments quils soient capacitifs, résistifs ou semi-conducteurs.

Dans un mode de réalisation particulier de l'invention, la couche conductrice forme un circuit ouvert. Ce mode de réalisation a pour but d'empêcher le développement d'une mutuelle inductance entre l'élément inductif et la couche conductrice superposée. Dans ce mode de réalisation, la couche conductrice formant un circuit ouvert ne peut être parcourue par un courant induit par le champ magnétique généré par l'élément inductif. Par conséquent la mutuelle inductance qui existe entre la couche conductrice et l'élément inductif est très faible.

Plus particulièrement, la couche conductrice peut inclure des segments conducteurs. Ces segments conducteurs permettent de minimiser les courants tourbillonnaires créés par le champ magnétique généré par l'élément inductif dans la couche conductrice. Les segments conducteurs peuvent être connectés à un cadre non fermé. L'ensemble fonctionne alors comme un circuit ouvert vis-à-vis d'un courant qui pourrait y être induit.

Dans un mode de réalisation préféré de l'invention, des tranches perpendiculaires à la spire de l'élément inductif sont creusées au sein du substrat. Le fond de ces tranches est recouvert par un matériau conducteur. La couche conductrice est ainsi située à l'intérieur du substrat et forme un blindage profond lorsqu'elle est connectée à une masse du circuit.

Dans un mode de réalisation avantageux de l'invention, le circuit intégré comporte en outre un puits en matériau faiblement résistif ou conducteur comportant des parois entourant entièrement l'élément inductif, ledit puits étant percé d'au moins une fente sur toute sa hauteur. L'élément inductif, lorsqu'il est placé au voisinage d'un autre élément inductif, crée une mutuelle inductance avec cet autre élément inductif. Cette mutuelle inductance tend à détériorer le facteur de qualité de l'élément inductif. Le puits permet de limiter le développement de ce phénomène en limitant l'interaction magnétique de l'élément inductif avec tout autre élément inductif présent dans le circuit. Une fente est percée sur toute la hauteur du puits pour empêcher l'établissement d'une boucle de courant à la surface du puits. Le circuit intégré étant composé d'une superposition de couches, chacune réalisée en un matériau faiblement résistif ou conducteur, les parois du puits peuvent être constituées par un empilement de pistes, chacune découpée au sein d'une desdites couches autour d'un périmètre délimité par la surface de l'élément inductif, lesdites pistes étant connectées entre elles. L'implémentation du puits par l'utilisation des couches existantes n'augmente pas l'encombrement du circuit. Avantageusement, le puits et la couche conductrice peuvent être reliés ensemble à une même borne de référence de potentiel, par exemple la masse du circuit, afin d'empêcher la création de capacités parasites.

Dans une variante de l'invention, le circuit intégré comporte deux éléments inductifs, tous deux connectés entre une borne de potentiel, qui peut être, suivant les besoins du circuit, soit une borne d'alimentation VCC de potentiel fixe ou variable, soit une borne de potentiel de référence ou masse GND, et une borne reliant l'élément inductif à un circuit. Ils sont destinés à être parcourus par un courant I circulant entre lesdites bornes. Ces deux éléments inductifs sont symétriques et réalisés à partir d'une seule et même spire. Le choix de la structure de cette spire influe sur la valeur de la mutuelle inductance qui s'établit lorsqu'un courant parcourt la spire et influe donc sur la valeur des facteurs de qualité des éléments inductifs réalisés à partir de la spire. Ce choix est fait de façon à optimiser le facteur de qualité desdits éléments inductifs. La dite spire sera avantageusement entourée d'un puits tel que décrit plus haut afin de réduire au maximum les interactions électromagnétiques entre lesdits éléments inductifs et d'autres éléments du circuit.

La présente invention peut être mise en oeuvre dans tout circuit intégré où un élément inductif coexiste avec d'autres éléments, qu'ils soient capacitifs, résistifs ou semiconducteurs. Le circuit intégré peut être par exemple un oscillateur, un mélangeur à charge active ou un filtre. Dans une de ses applications, l'invention concerne donc également un oscillateur destiné à délivrer un signal de sortie ayant une fréquence dont la valeur dépend de la valeur d'une tension de réglage, caractérisé en ce qu'il est réalisé sous la forme d'un circuit intégré tel que décrit plus haut, incluant, en outre, au moins une diode de type varicap, reliée à l'élément inductif et destinée à être polarisée au moyen de la tension de réglage.

Plus généralement, la présente invention peut être avantageusement mise en oeuvre dans un appareil récepteur de signaux radioélectriques. L'invention concerne donc un appareil récepteur de signaux radioélectriques comportant :
. un système d'antenne et de filtrage, permettant la réception d'un signal radioélectrique dont la fréquence, dite fréquence radio, est sélectionnée au sein d'une gamme de fréquences donnée, et sa transformation en un signal électronique dit signal radio,
. un oscillateur local dont la fréquence dite d'oscillation est réglable en fonction d'une tension de réglage, et
. un mélangeur, destiné à recevoir le signal radio et un signal provenant de l'oscillateur local et à délivrer un signal de sortie ayant une fréquence fixée et égale à la différence entre la fréquence radio et la fréquence d'oscillation, et
. une unité de traitement du signal destinée à exploiter le signal de sortie du mélangeur, appareil caractérisé en ce que l'oscillateur local est conforme à l'oscillateur décrit précédemment.

L'invention sera mieux comprise à la lumière de la description suivante de quelques modes de réalisation, faite à titre d'exemple et en regard des dessins annexés, dans lesquels :
- la figure 1 est une vue de dessus d'un circuit intégré conforme à un mode de réalisation avantageux de l'invention,
- la figure 2 est une section représentant un circuit intégré conforme à un mode de réalisation préféré de l'invention,
- la figure 3 est une vue de dessus de deux éléments inductifs présents dans un circuit selon une variante de l'invention,
- la figure 4 est un schéma fonctionnel d'un oscillateur conforme à un mode de mise en oeuvre particulier de l'invention,
- la figure 5 est un schéma fonctionnel d'un appareil récepteur de signaux radioélectriques comprenant un tel oscillateur.

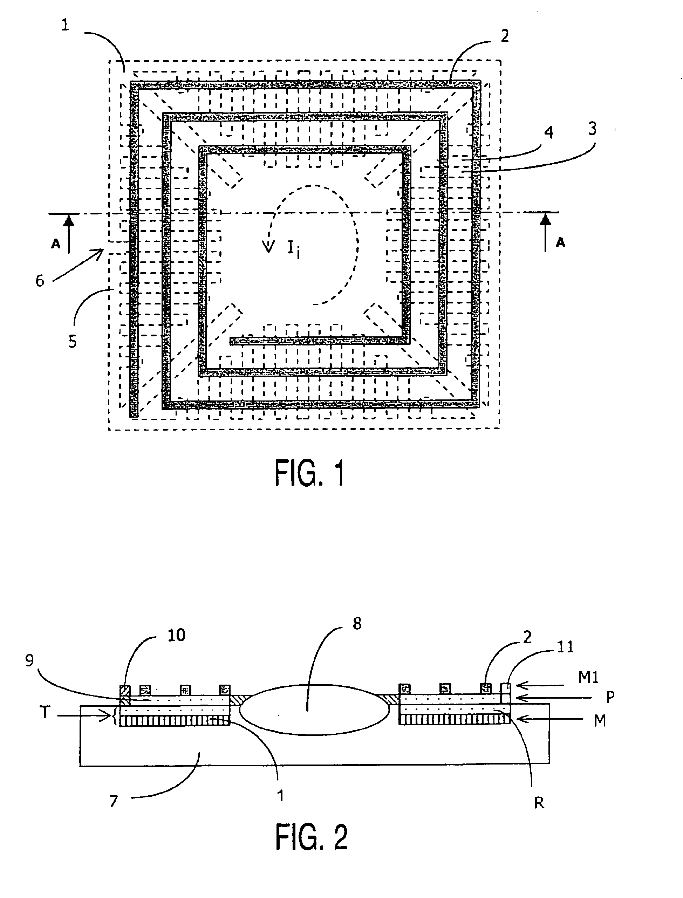

La figure 1 montre un circuit intégré comprenant une couche conductrice 1 et un élément inductif 2 superposé à ladite couche conductrice. L'élément inductif est constitué par une spire métallique présentant un contour extérieur et un contour intérieur délimitant entre eux une surface dite de rayonnement, et des moyens pour isoler la couche conductrice de l'élément inductif. La surface de la couche conductrice 1, représentée ici en pointillés, est substantiellement identique à la surface de rayonnement de l'élément inductif 2. Ceci permet l'intégration d'éléments de circuit sur une surface interne délimitée par le contour intérieur de l'élément inductif. Cette couche conductrice 1 est réalisée en matériau faiblement résistif ou conducteur et placée perpendiculairement aux vecteurs du champ magnétique développé par l'élément inductif 2. Elle peut comporter une alternance de bandes 3 et de fentes 4. Les bandes 3, qui constituent des segments conducteurs, peuvent, par exemple, être réalisées en un alliage métallique ou en polysilicium. La couche conductrice étant disposée perpendiculairement aux vecteurs du champ magnétique développé par l'élément inductif, un courant induit I pourrait apparaître dans la plaque si celle-ci était réalisée d'une seule pièce. L'alternance de fentes 4 et de bandes 3 disposées perpendiculairement à ce courant I forme un circuit ouvert empêchant la circulation d'un tel courant induit. Ce courant étant ainsi presque nul dans la couche conductrice, la mutuelle inductance qui peut apparaître entre la dite couche et l'élément inductif est, elle aussi, presque nulle et n'altère pas de manière significative le facteur de qualité de l'élément inductif. Les bandes sont connectées à l'extérieur sur un cadre 5 non fermé. Une fente 6 sur le cadre 5 empêche la formation d'une boucle de courant sur le cadre.

La figure 2 présente une section A-A, d'un circuit intégré selon un mode de réalisation préféré de l'invention, dans un plan défini sur la figure 1. Cette figure n'est qu'indicative d'un mode spécial de réalisation de la couche conductrice 1 décrite dans la figure 1. Le circuit comporte un substrat 7 qui peut être connecté à une borne de référence de potentiel et au sein duquel sont creusées des tranches T perpendiculaires à la spire de l'élément inductif. Le fond de ces tranches est recouvert par un matériau conducteur ou faiblement résistif M. Une couche conductrice conforme à la figure 1 peut ainsi être obtenue. Ces tranches sont finalement remplies d'un matériau isolant ou à forte résistivité constituant une couche isolante R.

Le substrat et une première couche conductrice P permettent de réaliser, dans l'espace laissé libre au centre de la spire de l'élément inductif, une zone dite active 8 qui comprend des éléments actifs, passifs ou semiconducteurs.

Par conception, la couche conductrice P, généralement en polysilicium, possède une structure particulière répondant aux besoins du circuit : n'occupant qu'une partie seulement de la surface globale du circuit, cette structure présente des interstices. En particulier, la surface où va être intégré l'élément inductif recouvre un tel interstice. Un matériau isolant ou fortement résistif comble ces interstices, formant une couche isolante 9 sur le même niveau que la couche conductrice P.

Dans le circuit intégré décrit ici, l'élément inductif est réalisé dans le matériau, par exemple un alliage métallique de type aluminium, formant une deuxième couche conductrice M1 du circuit de sorte que ledit élément inductif 2 est convoluté autour de la zone active 8.

Dans le mode de réalisation décrit ici, la couche conductrice 1 n'est pas adjacente à l'élément inductif 2. La deuxième couche M1, dans laquelle est incorporé l'élément inductif 2, et la couche conductrice 1, incorporée dans le substrat 7, sont en effet séparées par les couches isolantes R et 9. L'élément inductif 2 et la couche conductrice 1, considérés ensemble, peuvent former un élément L-C. Une capacité C formée entre l'élément inductif 2 et ladite couche conductrice 1 détériore le facteur de qualité de l'élément inductif 2. La valeur de cette capacité est fonction de la distance qui sépare la couche conductrice 1 de l'élément inductif 2. Pour minimiser cette valeur, la couche conductrice 1 est aussi éloignée que possible de l'élément inductif 2. Le facteur de qualité sera encore amélioré si la couche conductrice est réalisée en un matériau faiblement résistif ou conducteur, comme c'est le cas dans cet exemple. La connexion de la couche conductrice 1 à la borne de référence peut aussi permettre de limiter la valeur de cette capacité parasite. Dans le cas d'une couche conductrice 1 réalisée à l'intérieur du substrat 7 comme décrit plus haut, le contact entre la couche conductrice 1 et tout autre élément conducteur placé en surface du substrat est réalisé à l'aide de matériau conducteur ou faiblement résistif coulé sur les parois internes des tranches T lors de la réalisation de la couche conductrice 1 par coulage dudit matériau au fond des tranches. Le contact avec un élément conducteur placé en surface du substrat est ensuite réalisé en bordure desdites tranches T par connexion métallique.

Le facteur de qualité de l'élément inductif 2 peut aussi être affecté par la présence d'une deuxième capacité qui peut apparaître entre la couche conductrice 1 et le substrat 7. Le fait de connecter alors la couche conductrice 1 et le substrat 7 à une même borne de potentiel permet d'empêcher la formation de cette deuxième capacité parasite, et le facteur de qualité de l'élément inductif 2 n'est pas détérioré.

Dans le mode de réalisation décrit ici, un puits 10 réalisé en matériau conducteur est formé autour de l'élément inductif 2. Le puits 10 est percé sur toute sa hauteur d'une fente 11, identifiable par un plan non hachuré sur la figure, résultant d'une coupe partielle, qui interrompt toute circulation possible d'un courant induit par l'élément inductif 2 qu'il entoure. Ce puits 10 permet de minimiser les mutuelles inductances entre l'élément inductif 2 et des éléments de circuit présents dans le voisinage desdits éléments inductifs. Dans le mode de réalisation décrit ici, le puits 10 est réalisé par des jonctions de parties des couches P et M1. Ce puits est suffisamment haut pour assurer une bonne isolation de l'élément inductif 2 avec le reste du circuit et limiter ainsi les interactions magnétiques. De façon générale, chaque élément inductif ou partie d'élément inductif inclus dans le circuit intégré peut être isolé par un tel puits afin de minimiser les mutuelles inductances qui peuvent être développées entre cet élément inductif ou partie d'élément inductif et d'autres éléments présents dans le circuit.

Dans un mode de réalisation préféré de l'invention, la couche conductrice 1 et le puits 10 seront reliés ensemble à une borne de référence de potentiel. Les couplages capacitifs parasites entre la couche conductrice 1 et le substrat 7 d'une part, entre la couche conductrice 1 et l'élément inductif 2 d'autre part et enfin, entre la couche conductrice 1 et le puits 10 sont ainsi fortement limités. Les éléments inductifs inclus dans le circuit intégré selon cette variante de l'invention présenteront alors un facteur de qualité élevé.

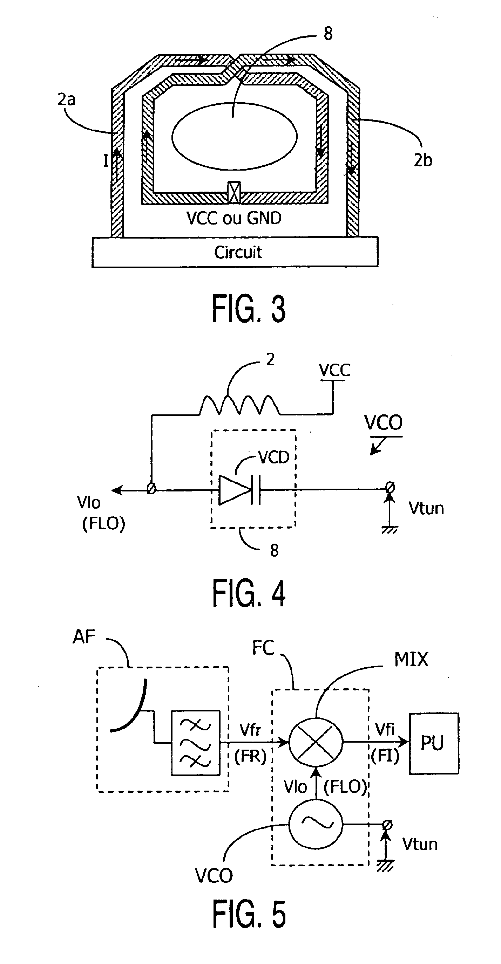

La figure 3 est une vue de dessus de deux éléments inductifs inclus dans un circuit intégré conforme à une variante de l'invention. Le circuit présenté est composée d'une seule spire. Cette spire inclut deux éléments inductifs 2a et 2b, hachurés différemment sur la figure. Ces deux éléments inductifs sont symétriques et imbriqués l'un dans l'autre. Ils sont tous deux connectés entre une borne de potentiel, qui peut être, suivant les besoins du circuit, soit une borne d'alimentation VCC de potentiel fixe ou variable, soit une borne de potentiel de référence ou masse GND, et une borne reliant l'élément inductif 2 à un circuit et destinés à être parcourus par un courant I circulant entre lesdites bornes. Dans ces deux éléments inductifs, le courant circule dans le même sens à chaque instant, ceci conformément à la figure 3. La mutuelle inductance entre deux fils conducteurs voisins et parallèles est dépendante du sens de parcours de l'intensité. Lorsque les sens de parcours de l'intensité sont opposés, la mutuelle inductance se soustrait à l'inductance propre de chaque fil. Lorsque les sens de parcours sont identiques, la mutuelle inductance s'ajoute à l'inductance propre de chaque fil. Dans la structure proposée ici, les parties de spires voisines sont parcourues par des courants de sens identique : on augmente ainsi les inductances des deux éléments inductifs et leur facteur de qualité. Par conséquent, on augmente les performances du circuit. En application de l'invention, une couche conductrice conforme à celle présentée sur la figure 1 est avantageusement réalisée par superposition de ladite couche conductrice et de la spire constituant les éléments inductifs 2a et 2b.Ces deux éléments inductifs peuvent ainsi présenter des facteurs de qualité élevés. Cette structure permet de disposer d'une surface interne où l'intégration d'une zone active 8 est possible.

La figure 4 est un schéma fonctionnel d'un oscillateur VCO réalisé sous la forme d'un circuit intégré conforme à l'invention. Cet oscillateur VCO est destiné à fournir un signal de tension Vlo ayant une fréquence FLO dont la valeur dépend de celle d'une tension de réglage Vtun. Cet oscillateur comprend un élément inductif 2, connecté à une borne d'alimentation VCC, et une zone active 8 comportant une diode de type varicap VCD destinée à être polarisée au moyen de la tension de réglage Vtun. Comme la diode varicap VCD présente une capacité variable en fonction de la valeur de sa tension de polarisation, la fréquence de résonnance du circuit L-C est aussi variable.

La figure 5 représente schématiquement un appareil récepteur de signaux radioélectriques, comportant un système d'antenne et de filtrage AF, permettant la réception d'un signal radioélectrique dont la fréquence FR, dite fréquence radio, est sélectionnée au sein d'une gamme de fréquences donnée, et sa transformation en un signal électronique Vfr dit signal radio. Cet appareil récepteur comporte en outre un convertisseur de fréquence FC, comprenant un oscillateur local VCO et un mélangeur MIX, lequel est destiné à recevoir le signal radio Vfr et un signal Vlo provenant de l'oscillateur local VCO dont la fréquence FLO, dite d'oscillation, est réglable, et à délivrer un signal de sortie Vfi ayant une fréquence FI fixée et égale à la différence entre la fréquence radio FR et la fréquence d'oscillation FLO.

Dans ce convertisseur de fréquence FC, le choix de la valeur de la fréquence d'oscillation FLO, effectué au moyen d'une tension de réglage Vtun, impose la valeur de la fréquence radio FR, puisque la fréquence intermédiaire FI est rendue fixe, par exemple à l'aide d'un système de filtrage non représenté sur la figure qui serait disposé en sortie du mélangeur MIX. Cet appareil récepteur comporte enfin une unité de traitement du signal PU destinée à exploiter le signal de sortie du mélangeur MIX.

L'invention permet d'obtenir une grande pureté spectrale pour le signal de sortie de l'oscillateur local VCO du fait du facteur de qualité élevé des éléments inductifs inclus dans ledit oscillateur. Cette pureté spectrale permet une sélection précise de la fréquence radio et, grâce à l'invention, n'est pas obtenue au prix d'un encombrement élevé de l'oscillateur local VCO.

## Revendications

1. Circuit intégré comprenant :
un substrat (7),
une couche conductrice (1),
au moins un élément inductif (2) superposé à la couche conductrice, constitué par une spire métallique présentant un contour extérieur et un contour intérieur délimitant entre eux une surface dite de rayonnement, et
des moyens (R) pour isoler la couche conductrice (1) de l'élément inductif (2),
circuit intégré **caractérisé en ce que** la couche conductrice (1) possède une surface substantiellement identique à la surface de rayonnement, et **en ce qu'**une zone active (8), qui comprend des éléments capacitifs, résistifs ou semiconducteurs, est intégrée sur une surface interne non recouverte par la surface de rayonnement, délimitée par le contour intérieur de la surface de rayonnement.

2. Circuit intégré selon la revendication 1, **caractérisé en ce que** la couche conductrice (1) forme un circuit ouvert.

3. Circuit intégré selon la revendication 1, **caractérisé en ce que** la couche conductrice (1) inclut des segments conducteurs (3).

4. Circuit intégré selon la revendication 3, **caractérisé en ce que** les segments conducteurs (3) sont connectés à un cadre (5) non fermé.

5. Circuit intégré selon la revendication 3, **caractérisé en ce qu'**au sein du substrat sont creusées des tranches perpendiculaires à la spire de l'élément inductif, tranches (T) dont le fond est recouvert par un matériau conducteur ou faiblement résistif qui constitue la couche conductrice.

6. Circuit intégré selon la revendication 1, **caractérisé par** la présence d'un puits (P) en matériau faiblement résistif ou conducteur comportant des parois entourant entièrement l'élément inductif, ledit puits étant percé d'au moins une fente sur toute sa hauteur, interrompant ainsi son parcours autour l'élément inductif.

7. Circuit intégré selon la revendication 1, **caractérisé en ce qu'**il comporte deux éléments inductifs (2a,2b), tous deux connectés entre une borne de potentiel donné et une borne reliant l'élément inductif à un circuit, lesdits éléments étant réalisés à partir d'une seule et même spire.

8. Oscillateur destiné à délivrer un signal de sortie ayant une fréquence dont la valeur dépend de la valeur d'une tension de réglage, **caractérisé en ce qu'**il est réalisé sous la forme d'un circuit intégré conforme à la revendication 1, et **en ce qu'**il inclut en outre au moins une diode (8) de type varicap reliée à l'élément inductif (2) et destinée à être polarisée au moyen de la tension de réglage.

9. Appareil récepteur de signaux radioélectriques, comportant :
un système d'antenne et de filtrage (AF), permettant la réception d'un signal radioélectrique ayant une fréquence, dite fréquence radio, sélectionnée au sein d'une gamme de fréquences donnée, et sa transformation en un signal électronique dit signal radio,
un oscillateur (VCO) local ayant une fréquence, dite d'oscillation, réglable au moyen d'une tension de réglage, et
un mélangeur (MIX), destiné à recevoir le signal radio et un signal provenant de l'oscillateur local et à délivrer un signal de sortie ayant une fréquence fixée et égale à la différence entre la fréquence radio et la fréquence d'oscillation, et
une unité de traitement du signal destinée à exploiter le signal de sortie du mélangeur, appareil **caractérisé en ce que** l'oscillateur local est conforme à la revendication 8.

## Claims

1. An integrated circuit comprising:
a substrate (7),
a conductive layer (1),
at least one inductive element (2) superimposed to the said conductive layer, made of one metallic turn having an outer outline and an inner outline delimiting a so called radiating area between them, and
means (R) for isolating the conductive layer (1) from the inductive element (2),
integrated circuit **characterised in that** the conductive layer (1) has a surface substantially equivalent to the radiating area, and **in that** an active region (8), that comprises capacitive, resistive or semiconductor elements, is integrated on an internal surface non coated with the radiating area, delimited by the inner profile of the radiating area.

2. An integrated circuit as claimed in claim 1, **characterised in that** the conductive layer (1) is an open circuit.

3. An integrated circuit as claim in claim 1, **characterised in that** the conductive layer (1) includes conductive segments (3).

4. An integrated circuit as claimed in claim 3, **characterised in that** the conductive segments (3) are connected to an unclosed frame (5).

5. An integrated circuit as claimed in claim 3, **characterised in that** trenches perpendicular to the inductive element turn are recessed within the substrate; bottom of which trenches (T) being coated with a conductor material or having a low resistivity, which material makes the conductive layer.

6. An integrated circuit as claimed in claim 1, **characterised by** the presence of a well (P) made of a low-resistivity material or conductive material comprising walls wholly surrounding the inductive element, the said well being recessed with at least one slot on its whole height, thereby breaking its path around inductive element.

7. An integrated circuit as claimed in claim 1, **characterised in that** it comprises two inductive elements (2a, 2b), both of which are connected between terminal having a given potential and a terminal coupling the inductive element with a circuit, the said elements being achieved from one and only turn.

8. An oscillator for providing an output signal having a frequency, value of which is depending on the control voltage, **characterised in that** it is carried out as an integrated circuit according to claim 1, and **in that** furthermore includes at least one voltage-variable capacitor type diode (8) connected to the inductive element (2) and designed to be biased by means of the control voltage.

9. A receiver device of radio electric signals, comprising:
an antenna and filtering system (AF) for receiving a radio electric signal having a so-called radio frequency, selected in a range of given frequencies and its conversion into an electronic signal, called radio signal,
a local oscillator (VCO) having a so-called oscillation frequency adjustable by means of a control voltage, and
a mixer (MIX) for receiving the radio signal and a signal coming from the local oscillator and for providing an output signal having a fixed frequency that is equal to the difference between the radio frequency and the oscillation frequency, and
a signal processing unit for operating the mixer output signal, the device being **characterised in that** the local oscillator is according to the claim 8.

## Patentansprüche

1. Integrierte Schaltung, die umfasst:
ein Substrat (7),
eine leitende Schicht (1),
wenigstens ein induktives Element (2), das der leitenden Schicht überlagert ist und durch eine metallische Windung gebildet ist, die einen äußeren Umriss und einen inneren Umriss besitzt, die zwischen sich eine so genannte Strahlungsfläche begrenzen, und
Mittel (R) zum Isolieren der leitenden Schicht (1) gegenüber dem induktiven Element (2),
wobei die integrierte Schaltung **dadurch gekennzeichnet ist, dass** die leitende Schicht (1) eine Oberfläche besitzt, die mit der Strahlungsoberfläche im Wesentlichen übereinstimmt, und dass eine aktive Zone (8), die kapazitive Elemente, resistive Elemente oder Halbleiterelemente enthält, in eine innere Oberfläche integriert ist, die nicht von der Strahlungsoberfläche bedeckt ist und durch den inneren Umriss der Strahlungsoberfläche begrenzt ist.

2. Integrierte Schaltung nach Anspruch 1, **dadurch gekennzeichnet, dass** die leitende Schicht (1) einen offenen Schaltkreis bildet.

3. Integrierte Schaltung nach Anspruch 1, **dadurch gekennzeichnet, dass** die leitende Schicht (1) Leitersegmente (3) enthält.

4. Integrierte Schaltung nach Anspruch 3, **dadurch gekennzeichnet, dass** die Leitersegmente (3) mit einem nicht geschlossenen Rahmen (5) verbunden sind.

5. Integrierte Schaltung nach Anspruch 3, **dadurch gekennzeichnet, dass** in dem Substrat Einschnitte, die zu der Windung des induktiven Elements senkrecht sind, ausgebildet sind; wobei der Boden der Einschnitte (T) durch ein Leitermaterial oder ein schwach resistives Material, das die leitende Schicht bildet, bedeckt ist.

6. Integrierte Schaltung nach Anspruch 1, **gekennzeichnet durch das** Vorhandensein eines Topfs (P) aus einem schwach resistiven Material oder einem Leitermaterial, der Wände besitzt, die das induktive Element vollständig umgeben, wobei **durch** den Topf wenigstens ein Schlitz über dessen gesamte Höhe verläuft, der somit seinen Weg um das induktive Element unterbricht.

7. Integrierte Schaltung nach Anspruch 1, **dadurch gekennzeichnet, dass** sie zwei induktive Elemente (2a, 2b) umfasst, die zwischen einem Anschluss mit gegebenem Potential und einem Anschluss, der das induktive Element mit einer Schaltung verbindet, miteinander verbunden sind, wobei die Elemente aus ein und derselben Windung verwirklicht sind.

8. Oszillator, der dazu vorgesehen ist, ein Ausgangssignal mit einer Frequenz zu liefern, deren Wert von dem Wert einer Steuerspannung abhängt, **dadurch gekennzeichnet, dass** er in Form einer integrierten Schaltung nach Anspruch 1 verwirklicht ist und dass er außerdem wenigstens eine Diode (8) des Typs Varicap, die mit dem induktiven Element (2) verbunden ist und dazu vorgesehen ist, mittels der Steuerspannung vorgespannt zu werden, enthält.

9. Empfängervorrichtung für radioelektrische Signale, die umfasst:
ein Antennen- und Filterungssystem (AF), das den Empfang eines radioelektrischen Signals mit einer so genannten Radiofrequenz, die aus einem gegebenen Frequenzbereich ausgewählt ist, und seine Transformation in ein elektronisches so genanntes Radiosignal ermöglicht,
einen Hilfsoszillator (VCO) mit einer so genannten Oszillationsfrequenz, die mittels einer Steuerspannung steuerbar ist,
einen Mischer (MIX), der dazu vorgesehen ist, das Radiosignal und ein von dem Hilfsoszillator stammendes Signal zu empfangen und ein Ausgangssignal zu liefern, das eine feste Frequenz besitzt, die gleich der Differenz zwischen der Radiofrequenz und der Oszillationsfrequenz ist, und
eine Signalverarbeitungseinheit, die dazu vorgesehen ist, das Ausgangssignal des Mischers auszuwerten, wobei die Vorrichtung **dadurch gekennzeichnet ist, dass** der Hilfsoszillator wie in Anspruch 8 definiert beschaffen ist.
